# EUROPEAN PATENT APPLICATION

(11) **EP 4 397 642 A1**
(43) Date of publication of application: **10.07.2024**
(21) Application number: 22864564.4
(22) Date of filing: 30.08.2022
(51) Int. Cl.: C04B 35/587, H05K 1/03

(54) **HIGHLY THERMALLY CONDUCTIVE SILICON NITRIDE SINTERED COMPACT, SILICON NITRIDE SUBSTRATE, SILICON NITRIDE CIRCUIT BOARD, AND SEMICONDUCTOR DEVICE**

(30) Priority: 03.09.2021 JP 2021143630
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: AOKI, Katsuyuki, Yokohama-shi, Kanagawa 235-0032 (JP); GOTO, Yasuhiro, Tokyo 105-0023 (JP); IWAI, Kentaro, Yokohama-shi, Kanagawa 235-0032 (JP); FUKASAWA, Takayuki, Yokohama-shi, Kanagawa 235-0032 (JP); YAMAGATA, Yoshihito, Yokohama-shi, Kanagawa 235-0032 (JP)
(74) Representative: Henkel & Partner mbB
(86) International application number: PCT/JP2022/032594
(87) International publication number: WO 2023/032982

(57) **Abstract**

The highly thermally conductive silicon nitride sintered compact according to an embodiment comprises silicon nitride crystal grains and a grain boundary phase. The silicon nitride sintered compact has a heat conductivity of 80 W/(m·K) or more. The average value of solute oxygen levels in the silicon nitride crystal grains present in a unit surface area of 20 µm × 20 µm in an arbitrary cross-sectional surface is 0.2 wt% or less. The average value of major axis diameters of the silicon nitride crystal grains present in a unit surface area of 50 µm × 50 µm in an arbitrary cross-sectional surface is 1 to 10 µm inclusive. The average value of aspect ratios of the silicon nitride crystal grains present in the unit surface area of 50 µm × 50 µm is 2 to 10 inclusive.

## Description

### [Technical Field]

Embodiments described below relate to a highly thermally conductive silicon nitride sintered body, a silicon nitride substrate, a silicon nitride circuit board, and a semiconductor device.

### [Background Art]

In recent years, there have been attempts to apply silicon nitride (Si₃N₄) substrates to semiconductor circuit boards. Alumina (Al₂O₃) substrates and aluminum nitride (AlN) substrates are used as semiconductor circuit boards. Alumina substrates have a thermal conductivity of about 30 W/(m·K) but can be less expensive. Also, aluminum nitride substrates can have better thermal conduction with a thermal conductivity of not less than 160 W/(m·K). On the other hand, for silicon nitride substrates, a substrate that has a thermal conductivity of not less than 50 W/(m·K) has been developed.

The thermal conductivity of a silicon nitride substrate is low compared with that of an aluminum nitride substrate. However, the three-point bending strength of a silicon nitride substrate is excellent at not less than 500 MPa. The three-point bending strength of an aluminum nitride substrate typically is about 300 to 400 MPa; and the strength tends to decrease as the thermal conductivity increases. A silicon nitride substrate can be thinner by taking advantage of the high strength. A thinner substrate makes it possible to reduce the thermal resistance, which improves the heat dissipation.

For example, Japanese Patent No. 6293772 (Patent Literature 1) discusses a silicon nitride substrate having a thermal conductivity of not less than 50 W/(m K) and a three-point bending strength of not less than 600 MPa. In Patent Literature 1, the distribution ratio of the grain boundary phase in the thickness direction of the substrate is controlled. As a result, in Patent Literature 1, the fluctuation of the dielectric strength is suppressed, and the temperature dependence of the volume specific resistance value is improved. Furthermore, in Patent Literature 1, the relative dielectric constants at 50 Hz and 1 kHz also are controlled.

In recent years, guaranteed operating temperatures have become high with the higher performance of semiconductor elements. For SiC elements and GaN elements, the guaranteed operating temperature is anticipated to be as high as about 250 °C. Also, the operating frequency of semiconductor elements is anticipated to become as high as about 1 MHz. Therefore, silicon nitride substrates also must maintain insulation properties in a high-temperature environment of about 250 °C or in a highfrequency environment of about 1 MHz.

Although the silicon nitride substrate described in Patent Literature 1 has good insulation properties, even greater performance improvement is desirable in recent years.

### [Prior Art Documents]

### [Patent Literature]

Patent Literature 1: Japanese Patent No. 6293772
Patent Literature 2: JP-A 2018-24548 (Kokai)
Patent Literature 3: JP-A 2022-71426 (Kokai)

### [Summary of Invention]

### [Problem to be Solved by Invention]

By investigating the cause, it was found that the cause is affected by the solid solution oxygen amount in the silicon nitride crystal grains. Solid solution oxygen occurs when a portion of the crystal lattice of the silicon nitride crystal is replaced with an oxygen element or by oxygen penetrating between the crystal lattice. That is, solid solution oxygen is oxygen incorporated into silicon nitride crystal grains. Solid solution oxygen is discriminated from oxygen existing in the grain boundary phase of the silicon nitride sintered body. Also, it has been necessary to control the solid solution oxygen amount because solid solution oxygen causes crystal lattice defects.

For example, JP-A 2018-24548 (Kokai) (Patent Literature 2) discusses a silicon nitride sintered body having a solid solution oxygen concentration of the silicon nitride crystal grains of 1 to 2500 ppm. In Patent Literature 2, secondary ion mass spectrometry (SIMS) is used to measure the solid solution oxygen amount. In Patent Literature 2, a raster area of 3 µm is set. According to the method of Patent Literature 2, the solid solution oxygen amount can be measured in silicon nitride crystal grains of 3 µm or more. The solid solution oxygen amount for silicon nitride crystal grains in the silicon nitride sintered body of 3 µm or less could not be measured. Also, because SIMS is a surface analysis method, the method is susceptible to oxidization of the sample surface. Therefore, it cannot be said that the control of the solid solution oxygen amount in the silicon nitride sintered body was always sufficient.

The invention is directed to address such problems, and to provide a highly thermally conductive silicon nitride sintered body in which the solid solution oxygen amount is controlled.

### [Means for Solving Problem]

A highly thermally conductive silicon nitride sintered body according to an embodiment includes silicon nitride crystal grains and a grain boundary phase; a thermal conductivity of the silicon nitride sintered body is not less than 80 W/(m K); an average value of solid solution oxygen amounts of the silicon nitride crystal grains existing in a 20 µm×20 µm unit area in any cross section is not more than 0.2 wt%; an average value of major diameters of the silicon nitride crystal grains existing in a 50 µm×50 µm unit area in any cross section is not less than 1 µm and not more than 10 µm ; and an average of aspect ratios of the silicon nitride crystal grains existing in the 50 µm×50 µm unit area is not less than 2 and not more than 10.

### [Brief Description of Drawings]

[FIG. 1]

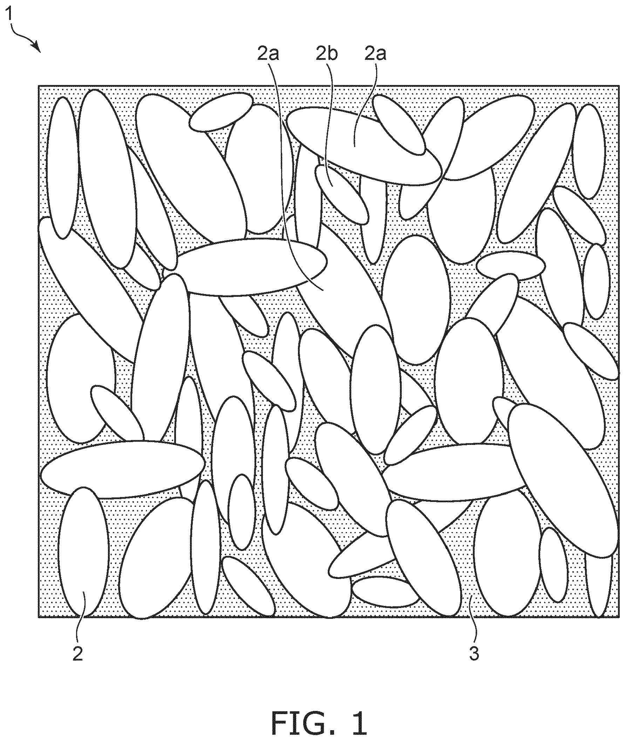

   FIG. 1 is a schematic view showing an example of a cross-sectional composition of a silicon nitride sintered body according to an embodiment.
[FIG. 2]

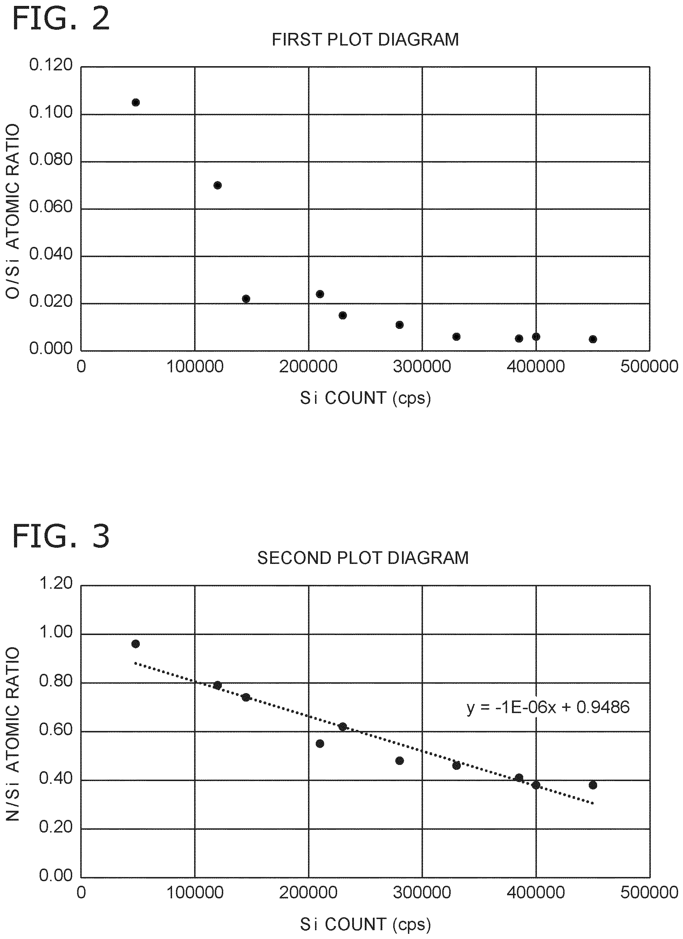

   FIG. 2 shows an example of a first plot diagram.
[FIG. 3]
   FIG. 3 shows an example of a second plot diagram.
[FIG. 4]

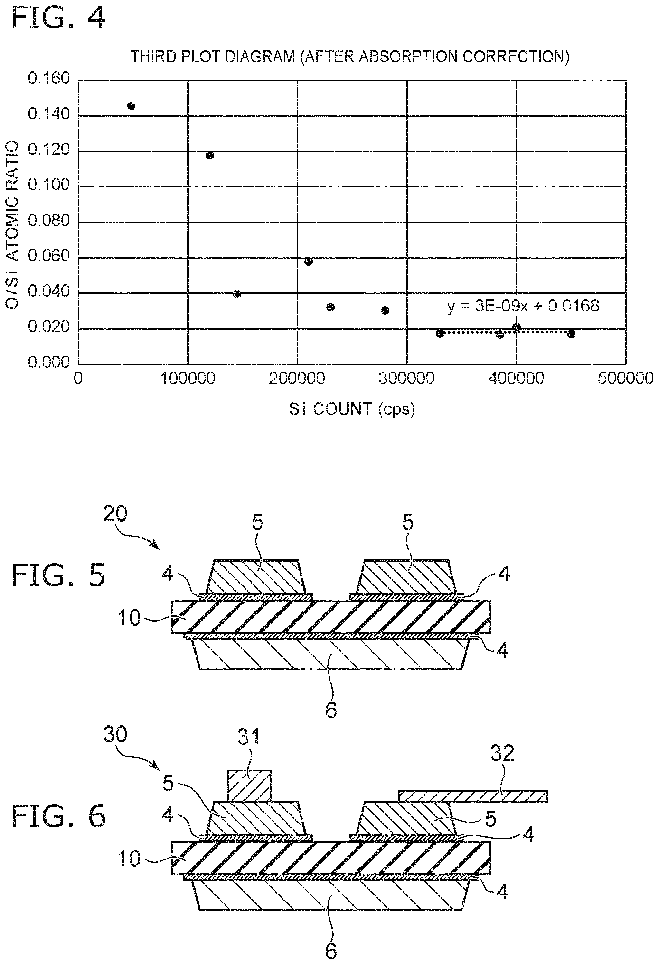

   FIG. 4 shows an example of a third plot diagram.
[FIG. 5]
   FIG. 5 is a schematic view showing an example of a silicon nitride circuit board according to an embodiment.
[FIG. 6]
   FIG. 6 is a schematic view showing an example of a semiconductor device according to an embodiment.

### [Embodiments of Invention]

A highly thermally conductive silicon nitride sintered body according to an embodiment includes silicon nitride crystal grains and a grain boundary phase; a thermal conductivity of the silicon nitride sintered body is not less than 80 W/(m K); an average value of solid solution oxygen amounts of the silicon nitride crystal grains existing in a 20 µm×20 µm unit area in any cross section is not more than 0.2 wt%; an average value of major diameters of the silicon nitride crystal grains existing in a 50 µm×50 µm unit area in any cross section is not less than 1 µm and not more than 10 µm; and an average of aspect ratios of the silicon nitride crystal grains existing in the 50 µm×50 µm unit area is not less than 2 and not more than 10.

FIG. 1 is a schematic view showing an example of a cross-sectional composition of a silicon nitride sintered body according to an embodiment. In FIG. 1, reference numeral 1 is a highly thermally conductive silicon nitride sintered body, reference numeral 2 is a silicon nitride crystal grain, and reference numeral 3 is a grain boundary phase. The highly thermally conductive silicon nitride sintered body 1 also is called simply the silicon nitride sintered body 1.

The silicon nitride sintered body 1 includes the silicon nitride crystal grains 2 and the grain boundary phase 3. The grain boundary phase 3 is distributed in gaps between the silicon nitride crystal grains 2. The grain boundary phase 3 is formed by a reaction of a sintering aid described below. Due to the existence of the grain boundary phase 3, the silicon nitride crystal grains 2 can be securely bonded to each other; and the silicon nitride sintered body 1 that has high thermal conductivity can be formed. Also, not-illustrated pores may exist in the silicon nitride sintered body 1.

The thermal conductivity of the silicon nitride sintered body 1 according to the embodiment is not less than 80 W/(m K). The heat dissipation is improved by the high thermal conductivity. It is therefore favorable for the thermal conductivity to be not less than 80 W/(m·K), or even not less than 100 W/(m K).

The average length of the major diameters of the silicon nitride crystal grains 2 is not less than 1 µm and not more than 10 µm. The average of the aspect ratios of the silicon nitride crystal grains 2 is not less than 2 and not more than 10.

A scanning electron microscope (SEM) photograph is used to measure the average length of the major diameters and the average aspect ratio. The SEM photograph is imaged at 2000 times. Also, the maximum diameters of the individual silicon nitride crystal grains 2 in the SEM photograph are measured. The maximum diameters of the individual silicon nitride crystal grains 2 visible in the SEM photograph are used as the major diameters. The average value of the maximum diameters of the individual silicon nitride crystal grains 2 visible in a 50 µm×50 µm unit area is used as the average length of the major diameters.

The aspect ratio is calculated by major diameter/minor diameter. The major diameter is the maximum diameter described above. The length of the silicon nitride crystal grain along a line extending perpendicularly from the center point of the major diameter is used as the minor diameter. The average value of the aspect ratios of the individual silicon nitride crystal grains visible in a 50 µm×50 µm unit area is used as the average aspect ratio. The major diameter and the minor diameter are measured using the portions of the silicon nitride crystal grains visible in the SEM photograph. For example, when a silicon nitride crystal grain is overlapped by another silicon nitride crystal grain and the entire contour of the silicon nitride crystal grain cannot be seen, the major diameter and the minor diameter are measured using only the visible portions (portions visible in the SEM photograph). Also, for the silicon nitride crystal grains having contours that are cut off at edges of the SEM photograph of the 50 µm×50 µm unit area, the major diameter and the minor diameter are measured using only the visible portions (portions visible in the SEM photograph). The grain boundary phase may be removed by etching when it is difficult to confirm the contours of the silicon nitride crystal grains.

The average length of the major diameters of the silicon nitride crystal grains 2 is within the range of not less than 1 µm and not more than 10 µm. Also, the average aspect ratio of the silicon nitride crystal grains 2 is not less than 2 and not more than 10. Within these ranges, the thermal conductivity can be improved. Also, the strength can be increased.

When the average length of the major diameters is less than 1 µm, there is a possibility that the silicon nitride crystal grains 2 may be too small, and the thermal conductivity may decrease. Also, when large, i.e., greater than 10 µm, there is a possibility that the strength may decrease even though the thermal conductivity improves. When the average aspect ratio is less than 2, there is a possibility that the strength may decrease because slender silicon nitride crystal grains are few. When the average aspect ratio is greater than 10, there is a possibility that the gap between the silicon nitride crystal grains may become large. The grain boundary phase becomes large when the gap between the silicon nitride crystal grains becomes large. There is a possibility that a large grain boundary phase may cause the thermal conductivity to decrease.

Also, as shown in FIG. 1, it is favorable for silicon nitride crystal grains 2a (first silicon nitride crystal grains) that have major diameters of less than 5 µm and silicon nitride crystal grains 2b (second silicon nitride crystal grains) that have major diameters of not less than 5 µm to exist. The existence of small crystal grains and large crystal grains makes it possible for small crystal grains to exist in the gaps of the large crystal grains. As a result, the thermal conductivity and the strength can be increased. From this perspective, it is more desirable for the silicon nitride crystal grains 2b having major diameters of less than 3 µm to exist.

In the silicon nitride sintered body 1, the solid solution oxygen amounts of the silicon nitride crystal grains 2 existing in a 20 µm×20 µm unit area of any cross section is not more than 0.2 wt%.

TEM-EDS is used to measure the solid solution oxygen amounts of the silicon nitride crystal grains 2. TEM is the abbreviation of transmission electron microscope. EDS is the abbreviation of energy dispersive X-ray spectroscope. A measurement method that uses TEM-EDS also is called simply EDS analysis. A measurement method of the solid solution oxygen amounts of the silicon nitride crystal grains 2 using EDS analysis is discussed in Japanese Patent Application No. 2020-180386 (Patent Literature 3).

Any cross section of the silicon nitride sintered body 1 is used as the sample for performing EDS analysis. The sample is taken from any cross section by focused-ion beam (FIB) processing or ion milling. It is favorable for the thickness of the sample to be within the range of not less than 0.05 µm and not more than 0.5 µm. To prevent surface oxidation of the sample, it is desirable to make and store the sample in a vacuum or an inert gas atmosphere.

JED-2300T made by JEOL Ltd. or an apparatus having equivalent or better performance is used as the EDS apparatus. JEM-200CX (acceleration voltage of 200 kV) made by JEOL Ltd. or an apparatus having equivalent or better performance is used for TEM. The recommended conditions of EDS analysis are an acceleration voltage of 200 kV, an irradiation current of 1.00 nA, and an analysis spot diameter of 1 nm. An analysis time of 30 seconds and a sample tilt angle of *X* = 10°, *Y* = 0° are recommended. Although the measurement conditions may be modified, the first plot diagram described below is measured using the recommended conditions described above.

By using TEM-EDS, the silicon nitride crystal grains can be selected as the measurement points.

Only large silicon nitride crystal grains could be measured in the measurements using SIMS as in Patent Literature 2. Also, even with nano SIMS in which the irradiation diameter can be small, the image recognition of the silicon nitride crystal grains was difficult. Therefore, the solid solution oxygen amounts of small silicon nitride crystal grains could not be measured.

A total dissolution method is another method for measuring the solid solution oxygen amount. A total dissolution method is a method in which the grain boundary phase of the silicon nitride sintered body is dissolved, and the silicon nitride crystal grains are extracted. The oxygen amounts of the extracted silicon nitride crystal grains are measured. However, it is difficult to dissolve and remove the grain boundary phase; and a reduction of the measurement accuracy, degradation of the reproducibility, etc., occurred due to the remaining grain boundary phase.

By setting the spot diameter of the measurement point of TEM-EDS to 1 nm, only the silicon nitride crystal grains can be included in the measurement points. Also, the solid solution oxygen amounts can be measured regardless of the size of the silicon nitride crystal grain.

First, in the EDS analysis, measurement points in at least ten locations among the silicon nitride crystal grains existing in a 20 µm×20 µm unit area are set. The ten locations are selected from different silicon nitride crystal grains 2 as much as possible. For example, one location measurement point is set in each of ten silicon nitride crystal grains. The atomic ratios of silicon (Si), oxygen (O), and nitrogen (N) are measured by the EDS analysis. The measurement points of ten or more locations are set so that not less than three measurement points have Si counts of not less than 300,000 cps. When less than three measurement points have Si counts of not less than 300,000 cps, the measurement points are increased until not less than three measurement points have Si counts of not less than 300,000 cps. The Si count being not less than 300,000 cps indicates that the oxygen amount can be measured without being affected by the surface oxygen. Therefore, the solid solution oxygen amounts of the silicon nitride crystal grains 2 can be measured even when the sample surface is naturally oxidized.

A first plot diagram is generated by plotting the atomic ratio of oxygen element/silicon element by Si count. In the first plot diagram, the horizontal axis is the Si count (cps), and the vertical axis is the O/Si atomic ratio. FIG. 2 shows an example of the first plot diagram. FIG. 3 shows an example of a second plot diagram. FIG. 4 shows an example of a third plot diagram. FIGS. 2 to 4 are plot diagrams based on measurement results of an example 3 described below.

Then, the second plot diagram is generated by plotting the atomic ratio of the nitrogen element/silicon element by the Si count. In the second plot diagram, the horizontal axis is the Si count (cps), and the vertical axis is the N/Si atomic ratio.

Then, the atomic ratio of the oxygen element/silicon element of the first plot diagram is corrected using the second plot diagram. This is because in the silicon nitride sintered body, the absorption of X-rays by oxygen (O), which is a light element, is greater than the absorption of X-rays by silicon (Si). The absorption characteristics of oxygen (O) and the absorption characteristics of nitrogen (N) are similar. Also, the main phase of the silicon nitride sintered body 1 is Si₃N₄; therefore, the theoretical value of the N/Si atomic ratio is 4/3. Therefore, the O/Si atomic ratio is corrected using the approximation data of the atomic ratio of Si and N. In the correction method, the O/Si atomic ratios of the first plot diagram are corrected using the N/Si atomic ratio of each measurement point of the second plot diagram. The correction is performed using the difference between the N/Si atomic ratio of each measurement point and 4/3 (= 1.33), which is the theoretical value. For example, the correction coefficient when the N/Si atomic ratio is 0.70 is 1.9 (= 1.33/0.70). The correction value is calculated by O/Si atomic ratio×correction coefficient. The O/Si atomic ratio of the first plot diagram is corrected by this method. The corrected first plot diagram is used as the third plot diagram.

In the third plot diagram, the horizontal axis is the Si count (cps), and the vertical axis is the O/Si atomic ratio after the correction. In the third plot diagram, multiple combinations of three or more measurement points are extracted. The straight-line approximation *y* = *aX* + *b* is calculated for each combination of measurement points. In the straight-line approximation *y* = *aX* + *b, X* is the horizontal axis, *y* is the vertical axis, *a* is the slope, and *b* is the intersect with the vertical axis (the y-axis). A straight-line approximation of which -4×10⁻⁸ ≤ *a* ≤ 4×10⁻⁸ is extracted from the multiple straight-line approximations thus obtained. The region in which the measurement points used for the extracted straight-line approximation exist is the convergence region in which the fluctuation of the O/Si atomic ratio is small. The straight-line approximation is generated using the approximation function of spreadsheet software. Examples of the spreadsheet software include Excel of Microsoft Corporation.

The convergence region obtained from the third plot diagram is a region in which the effects of the grain boundary phase and natural oxidation of the sample surface are minimized. When affected by the grain boundary phase and/or the natural oxidation of the sample surface, the fluctuation of the O/Si atomic ratio also increases. Therefore, the slope a is not within the range described above. The slope *a* of the straight-line approximation being within the range of not less than -4×10⁻⁸ and not more than 4×10⁻⁸ indicates that the fluctuation of the O/Si atomic ratio is reduced. It can be seen that the effects of the natural oxidation and/or the grain boundary phase are sufficiently reduced because the fluctuation of the O/Si atomic ratio is reduced. Therefore, the O/Si atomic ratio of the measurement points included in the convergence region indicate the solid solution oxygen amount.

Three measurement points are extracted in descending order of Si count in the convergence region. The solid solution oxygen amount is calculated using the average value of the O/Si atomic ratios. The average value of the O/Si atomic ratios of the three extracted measurement points is the value for which the effects of the natural oxidation and the grain boundary phase 3 are further reduced.

Because the silicon nitride crystal grains 2 are Si₃N₄, the solid solution oxygen amount (wt%) can be calculated using (3/7)×(average value of O/Si atomic ratios). This is a method in which the calculation is made from the oxygen amount corresponding to the Si amount in the Si₃N₄ crystal grain.

Also, the convergence region in which the slope *a* of the straight-line approximation of three or more points is within the range of not less than -4×10⁻⁸ and not more than 4×10⁻⁸ is determined from the three or more measurement points at which the Si count is not less than 300,000 cps. In the EDS analysis, it is not possible to selectively measure only points of 300,000 cps or more. Therefore, a method in which ten or more locations are measured by EDS analysis is effective. Ten or more locations are measured by EDS analysis; and the oxygen amount obtained by extracting the measurement points included in the convergence region and having Si counts of not less than 300,000 cps is the average value of the solid solution oxygen amounts of the silicon nitride crystal grains.

In the highly thermally conductive silicon nitride sintered body according to the embodiment, the solid solution oxygen amount measured by the method described above is not more than 0.2 wt%. The solid solution oxygen amount measured by TEM-EDS is the average value corresponding to the number of measurement points. That is, the average value of the solid solution oxygen amounts of the silicon nitride crystal grains existing in a 20 µm×20 µm unit area is not more than 0.2 wt%. Also, any cross-sectional composition means that the average value is not more than 0.2 wt% when the solid solution oxygen amounts of the silicon nitride crystal grains existing in a 20 µm×20 µm unit area is measured, no matter which unit area is measured.

Thus, the thermal conductivity of a silicon nitride sintered body in which the solid solution oxygen amount of the silicon nitride crystal grains is controlled can be improved. Furthermore, the relative dielectric constant characteristics can be improved. As described below, the frequency dependence and temperature dependence of the relative dielectric constant can be improved. Solid solution oxygen is a factor that reduces the thermal conductivity of the silicon nitride crystal grains. Also, lattice defects are caused. By controlling the solid solution oxygen amount, the cause of the lattice defects can be reduced. The thermal conductivity, relative dielectric constant, etc., degrade when the solid solution oxygen amount is greater than 0.2 wt%.

Also, it is favorable for the solid solution oxygen amount of each of the silicon nitride crystal grains existing in the 20 µm×20 µm unit area to be within the range of not less than 0.01 wt% and not more than 0.2 wt%. As described above, a method that uses TEM-EDS can use only the silicon nitride crystal grains as the measurement regions. By controlling the solid solution oxygen amounts of all of the silicon nitride crystal grains, the performance can be further improved. In the measurement of the solid solution oxygen amounts of the silicon nitride crystal grains, one or more measurement points is set in each individual silicon nitride crystal grain in the 20 µm×20 µm unit area. The analysis method is as described above. The analysis method is repeatedly performed until the measurement points set in the individual silicon nitride crystal grains are included in the convergence region, and the solid solution oxygen amount can be measured. The solid solution oxygen amount being not less than 0.01 wt% and not more than 0.20 wt% by setting the measurement points in the individual silicon nitride crystal grains indicates that the solid solution oxygen amounts of the individual silicon nitride crystal grains are controlled.

It is favorable for the difference between the solid solution oxygen amount of the first silicon nitride crystal grains 2a and the solid solution oxygen amount of the second silicon nitride crystal grains 2b to be not more than 0.03 wt%, wherein the first silicon nitride crystal grains 2a exist in the 20 µm×20 µm unit area and have major diameters of less than 5 µm, and the second silicon nitride crystal grains 2b exist in the 20 µm×20 µm unit area and have major diameters of not less than 5 µm. The solid solution oxygen amount obtained by setting measurement points only in the first silicon nitride crystal grains 2a in the 20 µm×20 µm unit area is taken as the "solid solution oxygen amount A". The solid solution oxygen amount obtained by setting measurement points only in the second silicon nitride crystal grains 2b is taken as the "solid solution oxygen amount B". It is favorable for |solid solution oxygen amount A - solid solution oxygen amount B| ≤ 0.03 wt%.

As described above, the existence of small silicon nitride crystal grains and large silicon nitride crystal grains can increase the thermal conductivity and strength. Regardless of the grain size, the thermal conductivity can be not less than 100 W/(m·K), or even as high as not less than 120 W/(m K) by suppressing the fluctuation of the solid solution oxygen amount.

Additionally, by reducing the solid solution oxygen amount difference between the small grains and the large grains, the relative dielectric constant can be more stable, and the electrical characteristics can be improved. The relative dielectric constant is the value of the electrical capacitance of a capacitor when a medium fills the space between the electrodes divided by the electrical capacitance when the space is a vacuum. According to the embodiment, the medium is the silicon nitride sintered body. The silicon nitride sintered body is an insulator and a dielectric; and an electric field causes polarization in the silicon nitride sintered body. The relative dielectric constant increases as the polarization increases. It was found that the solid solution oxygen amount affects the frequency dependence and temperature dependence of the relative dielectric constant. A higher relative dielectric constant may cause polarization to occur easily and cause degradation of the insulation properties. The solid solution oxygen causes lattice defects. Controlling the solid solution oxygen amount may improve the frequency dependence of the relative dielectric constant and improve the insulation properties. Conventionally, the solid solution oxygen amounts of only certain silicon nitride crystal grains could be measured. Therefore, the solid solution oxygen amount could not be controlled.

It is favorable for the content of the grain boundary phase 3 of the silicon nitride sintered body 1 to be not less than 1 mass% and not more than 20 mass%. The grain boundary phase 3 is formed by the reaction of the sintering aid with itself and by the reaction of the sintering aid with impurity oxygen and the like at the silicon nitride powder surface. Also, the grain boundary phase 3 has the effect of securely bonding the silicon nitride crystal grains 2 to each other and suppressing the occurrence of pores. By controlling the amount of the grain boundary phase 3, the characteristics that are dependent on the thermal conductivity, strength, and relative dielectric constant can be improved. The ratio of the grain boundary phase is low when the grain boundary phase is less than 1 mass%. Pores occur easily when the grain boundary phase 3 is low. Also, although the occurrence of pores can be suppressed when the grain boundary phase 3 is greater than 20 mass%, the thermal conductivity tends to decrease. It is therefore favorable for the content of the grain boundary phase 3 to be not less than 1 mass% and not more than 20 mass%, or even not less than 3 mass% and not more than 15 mass%. Also, by setting the porosity to be not more than 2% and the pore size to be not more than 20 µm, the strength can be not less than 500 MPa, or even not less than 600 MPa. A SEM photograph of the 50 µm×50 µm unit area described above can be used to measure the porosity and the pore size. The amount (mass%) of the grain boundary phase in the highly thermally conductive silicon nitride sintered body 1 can be determined by qualitative analysis and quantitative analysis of components other than silicon nitride. Also, when the added amount of the sintering aid can be ascertained, the added amount of the sintering aid may be considered to be the mass% of the grain boundary phase.

It is favorable for the grain boundary phase 3 to include at least one selected from a Group 2A element, a Group 3A element, and a Group 4A element. It is favorable for the grain boundary phase 3 to further include at least one selected from a rare-earth element, magnesium, titanium, and hafnium. The rare-earth element is yttrium (Y), a lanthanoid element, etc. Examples of the rare-earth element include at least one selected from yttrium (Y), erbium (Er), ytterbium (Yb), and cerium (Ce). Also, the sinterability can be improved by the grain boundary phase 3 including both a rare-earth element and magnesium. More favorably, the grain boundary phase 3 includes one or two of titanium or hafnium in addition to a rare-earth element and magnesium. Titanium or hafnium have the effect of reinforcing the grain boundary phase 3. Reinforcing the grain boundary phase 3 results in increased strength. The notations of Group 2A, Group 3A, and Group 4A are notations based on the Japanese periodic table. Be, Mg, Ca, Sr, Ba, and Ra are Group 2A elements; and Sc, Y, lanthanoid elements, and actinoid elements are Group 3A elements. Ti, Zr, and Hf are Group 4A elements.

According to such a silicon nitride sintered body 1, the relative dielectric constant at 50 Hz and room temperature can be not more than 10. Room temperature is 25 °C. The relative dielectric constant is determined by measuring the electrostatic capacitance. The electrostatic capacitance is the charge induced and stored in an electrode in an AC electric field. When the insulation properties are poor, the charge increases, and the electrostatic capacitance also increases. When the electrostatic capacitance increases, the relative dielectric constant also increases. That is, the relative dielectric constant is low when the insulation properties are good.

It is favorable for *ε*_{*50*-300}/*ε*_{*50*-25} to be within the range of not less than 0.9 and not more than 1.2, wherein *ε*_{*50*-25} is the relative dielectric constant at 50 Hz and room temperature, and *ε*_{*50*-300} is the relative dielectric constant at 50 Hz and 300 °C.

It is favorable for *ε*_{*1M*-300}/*ε*_{*1M*-25} to be within the range of not less than 0.9 and not more than 1.2, wherein *ε*_{*1M*-25} is the relative dielectric constant at 1 MHz and room temperature, and *ε*_{*1M*-300} is the relative dielectric constant at 1 MHz and 300 °C.

Also, it is favorable for *ε*_{*1M*-300}/*ε*_{*50*-300} to be within the range of not less than 0.8 and not more than 1.2.

The measurement of the relative dielectric constant is performed in accordance with JIS-C-2141 (1992). The complex permittivity measurement method (the three-terminal method) of JIS-C-2141 is used for the measurement. JIS-C-2141 corresponds to ISO 672-2.

The relative dielectric constant *ε*_{*50*-25} at 50 Hz and room temperature of the silicon nitride sintered body 1 according to the embodiment can be not more than 10. The relative dielectric constant *ε*_{*50*-25} being not more than 10 indicates that the polarization of the silicon nitride sintered body 1 can be suppressed at these conditions. This therefore indicates high insulative properties of the silicon nitride sintered body 1. Therefore, the reliability of a semiconductor device in which a semiconductor element is mounted to the silicon nitride sintered body 1 can be increased.

Also, *ε*_{*50*-300}/*ε*_{*50*-25} being within the range of not less than 0.9 and not more than 1.2 indicates that the change amount of the relative dielectric constant at 50 Hz is small even when the temperature changes. That is, this indicates that the temperature dependence of the relative dielectric constant at 50 Hz is small. Therefore, the characteristics that are dependent on the relative dielectric constant do not degrade easily even when the guaranteed operating temperature of the semiconductor element is increased.

Also, *ε*_{*1M*-300}/*ε*_{*1M*-25} being within the range of not less than 0.9 and not more than 1.2 indicates that the change amount of the relative dielectric constant at 1 MHz is small even when the temperature changes. That is, this indicates that the temperature dependence of the relative dielectric constant at 1 MHz is small. Therefore, the characteristics that are dependent on the relative dielectric constant do not degrade easily even when the guaranteed operating temperature of the semiconductor element is increased.

Also, *ε*_{*1M*-300}/*ε*_{*50*-300} being not less than 0.8 and not more than 1.2 indicates that the change amount of the relative dielectric constant is small even when the frequency changes. That is, the characteristics that are dependent on the relative dielectric constant do not degrade even when the operating frequency of the semiconductor element changes.

Also, it is favorable for each of *ε*_{*50-*300}/*ε*_{*50*-25}*, ε*_{*1M*-300}/*ε*_{*1M*-25}*,* and *ε*_{*1M*-300}/*ε*_{*50*-300} to be within the ranges described above.

The operating frequency of the semiconductor element varies from several 10 Hz to 1 MHz. The semiconductor element is a bipolar transistor, a MOSFET, an IGBT, a GTO, etc. Such a semiconductor element is called a power semiconductor. A power semiconductor can be switched on and off according to the operating frequency. Each semiconductor element has a different operating frequency range. By improving the temperature dependence and frequency dependence of the relative dielectric constant of the silicon nitride sintered body, the insulation properties are easily maintained regardless of the semiconductor element that is mounted. Therefore, a semiconductor device that has high reliability can be provided.

Therefore, the silicon nitride sintered body according to the embodiment is favorable for a silicon nitride substrate. Also, it is favorable for the thickness of the substrate to be not less than 0.1 mm and not more than 3 mm. Even when the thickness of the silicon nitride substrate is as thin as not less than 0.1 mm and not more than 3 mm, the reliability is high because the relative dielectric constant is improved. It is more favorable for the substrate to be within the range of not less than 0.1 mm and not more than 0.4 mm. Thinning the substrate has the effect of reducing the thermal resistance. Therefore, the heat dissipation improves.

The invention according to the embodiment is favorable for silicon nitride circuit boards in which a circuit part is located on the silicon nitride substrate. FIG. 5 is a schematic view showing an example of a silicon nitride circuit board according to an embodiment. In FIG. 5, reference numeral 4 is a bonding layer, reference numeral 5 is a metal plate (a front metal plate), reference numeral 6 is a metal plate (a back metal plate), reference numeral 10 is a silicon nitride substrate, and reference numeral 20 is a silicon nitride circuit board.

The metal plate 5 has a circuit configuration. The metal plate 5 is used as a circuit part for mounting a semiconductor element. The metal plate 5 that is used as the circuit part also is called the front metal plate. Also, the metal plate 6 is used as a heat dissipation plate. The metal plate 6 that is used as the heat dissipation plate also is called the back metal plate. Two front metal plates 5 are included in the example shown in FIG. 5. The front metal plate 5 is not limited to the illustrated example; the number of the front metal plates 5 is arbitrary. The back metal plate 6 may be used as a circuit part instead of a heat dissipation plate.

Examples of the metal plates 5 and 6 include copper plates, copper alloy plates, aluminum plates, aluminum alloy plates, etc. It is favorable for the metal plate to be a copper plate made of oxygen-free copper. As indicated in JIS-H-3100 (ISO 1337, etc.), oxygen-free copper has a copper purity of not less than 99.96 wt%. The thermal conductivity of the copper plate is about 400 W/(m K). The thermal conductivity of aluminum is about 240 W/(m K). Copper plates have higher thermal conductivities than aluminum plates. Therefore, the heat dissipation can be further improved by using the copper plate. Also, it is favorable for the thicknesses of the metal plates 5 and 6 to be within the range of not less than 0.2 mm and not more than 5 mm. The heat dissipation and the current-carrying capacity can be increased by making the metal plate thick.

Examples of the bonding layer 4 include an active metal bonding layer. When the metal plate is a copper plate, examples of the active metal bonding layer include a member that includes Ag or Cu as a major component and includes Ti. When the metal plate is an aluminum plate, examples of the active metal bonding layer include a member that includes Al as a major component and includes Si. The active metal bonding layer is a layer that includes Ti or Si as an active metal. Also, although an example is shown in which a metal plate is bonded as the circuit part, the invention according to the embodiment is not limited to such a configuration. The circuit part may be formed of a metal thin film or a metal thick film. The metal thin film is a metal film formed by a film formation method such as sputtering, vapor deposition, etc. Examples of the metal thin film include films of Ti, Pt, Au, Ni, Cu, Al, Ag, etc. The metal thick film is a film formed by firing a metal paste. The metal thick film is also called a metallized film. Examples of the metal thick film include films of Ag, Cu, Ti, W, Mo, etc.

FIG. 6 is a schematic view showing an example of a semiconductor device according to an embodiment. In FIG. 6, reference numeral 30 is a semiconductor device, reference numeral 31 is a semiconductor element, and reference numeral 32 is a leadframe. In the semiconductor device 30 shown in FIG. 6, the semiconductor element 31 is mounted to one of the two metal plates 5. The leadframe 32 is connected to the other of the two metal plates 5. The structure of the semiconductor device 30 according to the embodiment is not limited to the illustrated example. As necessary, the number and sizes of the metal plates 5, the number and sizes of the semiconductor elements 31, etc., are modifiable as appropriate. Also, the metal plate 6 may be used as a circuit part; and the semiconductor element 31 may be mounted to the metal plate 6.

A method for manufacturing the highly thermally conductive silicon nitride sintered body 1 according to the embodiment will now be described. The method for manufacturing the highly thermally conductive silicon nitride sintered body 1 according to the embodiment is not limited as long as the highly thermally conductive silicon nitride sintered body 1 has the configuration described above. Here, a method for obtaining the silicon nitride sintered body 1 with a high yield is illustrated.

First, a silicon nitride powder is prepared. It is favorable for the average particle size of the silicon nitride powder to be not more than 2.5 µm, and for the impurity oxygen content to be not more than 2 mass%. The impurity oxygen of the silicon nitride powder includes a component dissolved in the powder and a component adhered to the powder surface. The oxygen amount that is dissolved in the silicon nitride grains of the silicon nitride sintered body can be reduced as the impurity oxygen decreases. It is therefore favorable for the impurity oxygen amount of the silicon nitride powder to be not more than 2 mass%, or even not more than 1 mass%.

Silicon nitride powders are mainly manufactured by imide decomposition or direct nitriding. Imide decomposition is favorable because the impurity oxygen amount dissolved in the powder is low. Also, there are α-type and β-type silicon nitride powders. A β-silicon nitride powder can have low solid solution oxygen in the crystal structure. On the other hand, an α-silicon nitride powder is easily densified because the sinterability is higher than that of the β-type. A silicon nitride sintered body that has high strength can be obtained by using the α-type as the raw material powder. A silicon nitride powder may be used in which an α-silicon nitride powder and a β-silicon nitride powder are mixed. Also, when the total of the α-silicon nitride powder and the β-silicon nitride powder is taken as 100 parts by mass, it is favorable for the β-type to be within the range of not less than 1 part by mass and not more than 30 parts by mass. There is a possibility that the sinterability may degrade when the β-type is greater than 30 parts by mass. Also, there is a possibility that the effect of using the β-type may be insufficient when the β-type is less than 1 part by mass. Commercially available α-silicon nitride powders have an alpha percentage of not less than 90 wt%. That is, a small amount of a β-silicon nitride powder is unavoidably included in a commercially available α-silicon nitride powder. A material in which an α-silicon nitride powder and a β-silicon nitride powder are mixed means a material in which a β-silicon nitride powder is actively added to the commercially available α-silicon nitride powder. In other words, a material that is made of only an α-silicon nitride powder that unavoidably includes a β-silicon nitride powder is not treated as a material in which an α-silicon nitride powder and a β-silicon nitride powder are mixed.

Also, it is effective to perform treatment to reduce the impurity oxygen of the silicon nitride powder. Examples of the treatment to reduce the impurity oxygen include reduction treatment, chemical treatment, etc. Examples of reduction treatment include heat treatment in a hydrogen atmosphere, heat treatment in an atmosphere with carbon present, etc. Also, chemical treatment is a method of treating the silicon nitride powder in an acidic or alkaline solution.

Then, a sintering aid is prepared. The sintering aid promotes sintering, and is a component that becomes the grain boundary phase. At least one selected from a Group 2A element, a Group 3A element, and a Group 4A element is favorable in the sintering aid. The notations of Group 2A, Group 3A, and Group 4A are notations based on the Japanese periodic table. It is favorable for the sintering aid to further include at least one selected from a rare-earth element, magnesium, titanium, and hafnium. Titanium exists as titanium nitride (TiN) grains in the grain boundary phase. The titanium nitride grains have the effect of reinforcing the grain boundary phase by the pinning effect. It is favorable to add the sintering aid as an oxide powder. Oxides can form stable grain boundary phases by reacting with each other. More favorably, the sintering aid is a metal oxide powder having an average particle size of not more than 3 µm.

Then, a process of mixing the silicon nitride powder and the sintering aid powder is performed. Homogeneity of the sinterability is necessary to control the major diameter and aspect ratio of the silicon nitride crystal grains of the silicon nitride sintered body. It is therefore necessary to uniformly mix the silicon nitride powder and the sintering aid powder. In the sintering process, the sintering aid reacts to become the grain boundary phase. The growth reaction of the silicon nitride grains advances via the grain boundary phase. Oxygen escapes from the silicon nitride grains in this process. By uniformly mixing the silicon nitride powder and the sintering aid powder, the reaction can be homogenized via the grain boundary phase.

Also, a ball mill or a bead mill is used in the mixing process.

It is common for the silicon nitride powder and the sintering aid powder to exist as agglomerated secondary particles. The secondary particles are an obstructive factor of homogeneous sinterability. The homogeneity of the sinterability can be improved by uniformly mixing secondary particles while pulverizing the secondary particles into primary particles without agglomeration. In the mixing process that accompanies the pulverizing, it is favorable to apply a stress not so high as to further fracture the primary particles. Fracture surfaces are formed in the silicon nitride powder when the primary particles are fractured. The fracture surface is an active surface, and therefore an oxide film is formed for stabilization, and the oxygen adhesion amount increases. The oxygen amount exceeds the amount adhered to the primary particles. Accordingly, it is effective to suppress the formation of fracture surfaces on the primary particles.

Wet pulverization that uses a solvent is suited to such pulverization of the secondary particles. A solvent that has high wettability to the particle surface and low reactivity with the particles is used. Thus, low stress is necessary for the pulverization, and fracture of the primary particles can be suppressed. An organic solvent is suited to the mixing that accompanies the pulverization of the silicon nitride powder and the sintering aid powder. Alcohols and ketones are suited to the organic solvent. An organic solvent that is a mixture of an alcohol and a ketone may be used. Alcohol is a general term for a substance in which a portion of the hydrogen included in a hydrocarbon is replaced with a hydroxyl group (OH group). Also, ketones are substances represented by R-C(=O)-R'. R and R' are alkyl groups, etc. Such organic solvents have high wettability with the silicon nitride powder and the sintering aid powder and low reactivity with the powder. It is common to add the sintering aid powder as an oxide powder. A mixture of an alcohol and a ketone is desirable in a raw material composition in which a silicon nitride powder and an oxide powder are mixed. Also, a dispersant may be added as necessary. The dispersant has the effect of stabilizing the primary particles in the solvent and suppresses re-agglomeration. Examples of the dispersant include a surfactant, etc.

It is favorable for the diameter of the media when performing the pulverizing process by ball milling to be not more than 20 mm, or even not more than 12 mm. The media is a ceramic ball. Ball milling is a method in which the powder and the media are placed in a circular tubular container and the powder is pulverized while rotating the circular tubular container. A ball mill process that uses an organic solvent as described above is wet pulverization and mixing. Selecting an organic solvent suited to the powder is effective to reduce the stress necessary for pulverization. That is, pulverization is possible with a ceramic ball having a small media diameter; and an effect is provided in which the energy of the media impacting the powder is less. By reducing the energy of the media impacting the powder, the formation of fracture surfaces in the primary particles can be suppressed. It is favorable for the minimum value of the media diameter to be not less than 3 mm. When the media is too small, there is a possibility that the work efficiency may decrease.

It is favorable for the time of the wet pulverization and mixing by ball milling to be within the range of not less than 5 hours and not more than 40 hours. When the time is less than 5 hours, there is a possibility that the effects of the pulverization may be insufficient, and many secondary particles may remain. When the time is greater than 40 hours, the likelihood of fracture surfaces forming in the primary particles increases. It is therefore favorable for the time of the wet pulverization and mixing by ball milling to be within the range of not less than 5 hours and not more than 40 hours, or even not less than 10 hours and not more than 30 hours. Also, it is favorable for the rotational speed of the circular tubular container of the ball mill process to be within the range of not less than 50 rpm and not more than 500 rpm.

The pulverization of the secondary particles can be ascertained by checking the particle size distribution before and after pulverizing. As the secondary particles are pulverized and the primary particles increase, the peak position of the particle size distribution (the frequency distribution) shifts toward a smaller particle size. Also, the peak of the particle size distribution has a sharper shape.

The suppression of the fracture surface formation of the primary particles can be ascertained by measuring the oxygen amount before and after pulverizing. The oxygen amount before pulverizing is the oxygen amount of the raw material powder. There is no problem if the oxygen amount of the raw material powder after pulverizing has not drastically increased compared to before pulverizing.

A raw material powder slurry is obtained by performing a wet pulverization and mixing process. A forming process is performed to form a formed body using the raw material powder slurry. Examples of the molding process include sheet molding, die molding, etc. Sheet molding is a doctor blade method or the like. When sheet molding is performed, cutting is performed to cut an elongated sheet into the necessary size. The slurry may be used after being processed into a granulated powder or the like suited to the molding method.

A degreasing process of the formed body is performed. It is favorable for the degreasing process to be performed within the range of not less than 400 °C and not more than 800 °C. By performing the degreasing process, organic substances in the formed body can be removed. Also, a body after performing the degreasing process is called a degreased body.

Then, a sintering process of sintering the degreased body is performed. It is favorable for the sintering process to include a first holding process within the range of not less than 1500 °C and not more than 1650 °C, and a second holding process within the range of not less than 1750 °C and not more than 2000 °C.

The first holding process is a process of holding the degreased body within the range of not less than 1500 °C and not more than 1650 °C. It is favorable for the holding time to be not less than 2 hours. The temperature range of not less than 1500 °C and not more than 1650 °C corresponds to the temperature range in which grain growth of silicon nitride starts. Furthermore, the temperature range also corresponds to the temperature at which the impurity oxygen starts to desorb from the silicon nitride powder. The impurity oxygen desorbs as SiO (silicon monoxide). By performing the first holding process, the solid solution oxygen amount in the silicon nitride powder can be efficiently reduced. Then, the grain growth of the silicon nitride crystal grains can be homogenized. It is favorable for the holding time of the first holding process to be not more than 10 hours. When the holding time is greater than 10 hours, there is a possibility that the oxygen necessary for liquid phase generation which occurs with the sintering aid may be insufficient, and the sinterability may degrade. It is therefore favorable for the holding time of the first holding process to be not less than 2 hours and not more than 10 hours, or even not less than 3 hours and not more than 6 hours. Also, it is favorable for the holding process to be performed at a reduced-pressure atmosphere of atmospheric pressure (0.1 MPa) or less. In a so-called pressurized atmosphere that is greater than 0.1 MPa, there is a tendency for SiO desorption to be suppressed.

The second holding process is a process of holding the degreased body within the range of not less than 1750 °C and not more than 2000 °C. The holding temperature of the second holding process is the so-called sintering temperature. The sintered body can be densified in this temperature range. Also, the major diameter and aspect ratio of the silicon nitride crystal grains can be controlled. When the holding temperature is less than 1750 °C, there is a possibility that the densification may be insufficient. When the holding temperature is greater than 2000 °C, there is a possibility that grain growth of the silicon nitride crystal grains may be excessive. Also, it is favorable for the holding time of the second holding process to be within the range of not less than 5 hours and not more than 30 hours. It is favorable for the second holding process to be performed in a pressurized atmosphere of not less than 0.5 MPa. In a pressure atmosphere of 0.1 MPa (atmospheric pressure) or less, there is a possibility that densification may be insufficient because self-decomposition of silicon nitride easily occurs at 1700 °C or more.

It is favorable for the sintering process to be performed in a nonoxidizing atmosphere. Examples of the nonoxidizing atmosphere include a nitrogen atmosphere, an argon atmosphere, or a vacuum atmosphere. In the nonoxidizing atmosphere, dissolved oxygen in the silicon nitride crystal grain can be suppressed.

A sintered body can be obtained by the sintering process. Also, a reheat treatment of the sintered body may be performed. By using a process of holding the sintered body within the range of not less than 1400 °C and not more than 1600 °C as the reheat treatment, the SiO desorption can be more effectively promoted. Because the configuration of the sintered body has a stable crystal structure, unfavorable effects on the crystal structure by the SiO desorption of the reheat treatment are low. It is favorable for the holding time of the reheat treatment to be within the range of not less than 1400 °C and not more than 1600 °C for not less than 2 hours. It is favorable for the holding process also to be performed in a reduced-pressure atmosphere of atmospheric pressure (= 0.1 MPa) or less. In a so-called pressurized atmosphere that is greater than 0.1 MPa, there is a tendency for SiO desorption to be suppressed. It is favorable to perform the reheat treatment after the second holding process and after returning to room temperature. Also, after the second holding process, the sintered body may be treated by lowering the temperature to not more than 1300 °C, holding, and then again raising the temperature. 1300 °C or less is the temperature at which the liquid phase made from the sintering aid and the like solidifies and no longer contributes to the sintering reaction. In other words, similarly to the state of being returned to room temperature, the sintered body can be considered to be in a configuration in which a stable crystal structure is maintained; therefore, unfavorable effects on the crystal structure due to the SiO desorption of the reheat treatment are low.

Also, the maximum holding temperature in the reheat treatment is less than the holding temperature in the second holding process of the sintering. It is favorable for the difference between the maximum holding temperature of the reheat treatment and the holding temperature in the second holding process to be not less than 50 °C and not more than 300 °C. For example, when the holding temperature of the second holding process is 1800 °C, it is favorable for the reheat treatment temperature to be within the range of not less than 1500 °C and not more than 1750 °C. The reheat treatment not only desorbs the oxygen out of the sintered body as SiO, but also has the effect of suppressing the fluctuation of the solid solution oxygen amount between the silicon nitride crystal grains. Also, by setting the maximum holding temperature of the reheat treatment to be less than the holding temperature of the second holding process of the sintering, the grain growth of the silicon nitride crystal grains can be suppressed. It is favorable to perform the reheat treatment in a nonoxidizing atmosphere. By performing the reheat treatment in the nonoxidizing atmosphere, the incorporation of oxygen into the silicon nitride crystal grains can be suppressed.

The silicon nitride sintered body 1 according to the embodiment can be manufactured by the processes described above. Also, a silicon nitride substrate can be manufactured by making a substrate-shaped silicon nitride sintered body 1. A silicon nitride circuit board can be manufactured by performing a process of providing a circuit part in the silicon nitride substrate. A semiconductor device can be manufactured by mounting a semiconductor element to a circuit part of the silicon nitride circuit board.

### (Examples)

### (Examples 1 to 7 and comparative examples 1 to 3)

The silicon nitride powders shown in Table 1 were prepared. The mixing ratios are the mass ratios when the total of the α-type and the β-type is taken as 100 parts by mass. Also, a powder having an alpha percentage of not less than 90 wt% was used as the α-silicon nitride powder.

**[Table 1]**

| | α-silicon nitride powder | | | β-silicon nitride powder | | |
|---|---|---|---|---|---|---|
| | Mixing ratio (parts by mass) | Average particle size (µm) | Oxygen content (wt%) | Mixing ratio (parts by mass) | Average particle size (µm) | Oxygen content (wt%) |
| Silicon nitride powder 1 | 100 | 1.2 | 1.2 | - | - | - |
| Silicon nitride powder 2 | 80 | 0.9 | 1.4 | 20 | 1.7 | 0.7 |
| Silicon nitride powder 3 | 100 | 1.6 | 0.6 | - | - | - |
| Silicon nitride powder 4 | 100 | 1.7 | 2.3 | - | - | - |
| Silicon nitride powder 5 | 98 | 1.9 | 1.8 | 2 | 1.7 | 0.7 |

Then, the sintering aid powders shown in Table 2 were mixed. The average particle sizes of the sintering aid powders were not more than 3 µm. Also, the mixing ratios of the sintering aids are the ratios when the total of the silicon nitride powder and the sintering aid powder is taken as 100 mass%.

**[Table 2]**

| | Silicon nitride powder | Sintering aid (mass%) |
|---|---|---|
| Example 1 | Silicon nitride powder 1 | Er₂O₃ (5) , MgO (2) , HfO₂ (1) |
| Example 2 | Silicon nitride powder 1 | Y₂O₃ (6) , MgO (1) , HfO₂ (1) |
| Example 3 | Silicon nitride powder 2 | Y₂O₃ (3) ,MgO (2) , TiO₂ (0.5) |
| Example 4 | Silicon nitride powder 3 | Y₂O₃ (7) ,MgO (0.5) ,ZrO₂ (1) |
| Example 5 | Silicon nitride powder 3 | CeO₂ (6) ,MgO (1) ,HfO₂ (3) |
| Example 6 | Silicon nitride powder 5 | Y₂O₃ (4) ,Er₂O₃ (4) ,MgO (1) |
| Example 7 | Silicon nitride powder 5 | Y₂O₃ (5) ,MgO (1) |
| Comparative example 1 | Silicon nitride powder 1 | Y₂O₃ (3) ,MgO (1) ,TiO₂ (0.5) |
| Comparative example 2 | Silicon nitride powder 4 | Y₂O₃ (7) ,MgO (1) ,ZrO₂ (2) |
| Comparative example 3 | Silicon nitride powder 1 | Y₂O₃ (3) ,MgO (1) ,TiO₂ (0.5) |

Then, a wet pulverization and mixing process was performed by mixing an organic solvent into the silicon nitride powder and sintering aid powder. The wet pulverization and mixing process was performed by ball milling using the conditions of Table 3. The rotational speed of the circular tubular container of the ball mill was set to be within the range of not less than 50 rpm and not more than 500 rpm. In the comparative example 2, wet mixing was performed using water. In the comparative example 3, dry mixing was performed.

**[Table 3]**

| | Wet pulverization and mixing process | | |
|---|---|---|---|
| | Solvent | Media diameter (mm) | Time (h) |
| Example 1 | Ethanol | 10 | 20 |
| Example 2 | Methyl ethyl ketone | 10 | 25 |
| Example 3 | Propanol | 10 | 20 |
| Example 4 | Propanol+Methyl ethyl ketone | 20 | 15 |
| Example 5 | Ethanol | 30 | 20 |
| Example 6 | Ethanol | 10 | 25 |
| Example 7 | Ethanol | 10 | 25 |
| Comparative example 1 | Ethanol | 30 | 20 |
| Comparative example 2 | Water | 30 | 20 |
| Comparative example 3 | None (dry mixing) | 30 | 20 |

Raw material powder slurries were prepared by the wet pulverization and mixing process. Sheet molding was performed using the raw material powder slurries. The sheet molding was performed using a doctor blade method. Elongated sheets were cut into the prescribed size. Subsequently, degreased bodies were prepared by performing a degreasing process.

A sintering process of the degreased bodies was performed. A first holding process and a second holding process were performed as the sintering process. Also, a third holding process (a reheat treatment) was performed after the sintering process. The conditions of the sintering process were as shown in Tables 4 and 5. Also, the first holding process, the second holding process, and the third holding process were performed in a nonoxidizing atmosphere.

**[Table 4]**

| | First holding process | | Second holding process | |
|---|---|---|---|---|
| | Holding temperature Holding time (°C) (h) | | Holding temperature (°C) | Holding time (h) |
| Example 1 | 1550 | 5 | 1900 | 10 |
| Example 2 | 1600 | 6 | 1950 | 6 |
| Example 3 | 1550 | 4 | 1850 | 12 |
| Example 4 | 1620 | 3 | 1800 | 20 |
| Example 5 | 1500 | 3 | 1850 | 12 |
| Example 6 | 1650 | 4 | 1870 | 9 |
| Example 7 | 1580 | 4 | 1920 | 8 |
| Comparative example 1 | None | - | 1900 | 6 |
| Comparative example 2 | 1500 | 3 | 1900 | 10 |
| Comparative example 3 | 1500 | 3 | 1900 | 10 |

**[Table 5]**

| | Third holding process | |
|---|---|---|
| | Holding temperature (°C) | Holding time (h) |
| Example 1 | 1850 | 6 |
| Example 2 | 1800 | 6 |
| Example 3 | 1700 | 8 |
| Example 4 | 1650 | 5 |
| Example 5 | None | - |
| Example 6 | 1630 | 5 |
| Example 7 | 1720 | 5 |
| Comparative example 1 | 1800 | 6 |
| Comparative example 2 | 1500 | 10 |
| Comparative example 3 | 1500 | 10 |

Silicon nitride sintered bodies according to the examples and comparative examples were manufactured by the sintering process described above. The silicon nitride sintered bodies were patterned into silicon nitride substrates that were 100 mm long×80 mm wide. Silicon nitride substrates having thicknesses of 0.32 mm were made for the examples 1 to 3, the examples 6 to 7, and the comparative examples 1 to 3. Silicon nitride substrates having thicknesses of 0.25 mm were made for the examples 4 to 5. The content of the grain boundary phase was within the range of not less than 1 mass% and not more than 20 mass% for the silicon nitride substrates according to the examples and comparative examples.

The solid solution oxygen amounts of the silicon nitride crystal grains and the average length of the major diameters and average aspect ratio of the silicon nitride crystal grains included in the silicon nitride substrate were measured.

To measure the solid solution oxygen amounts of the silicon nitride crystal grains, a 20 µm×20 µm unit area of an arbitrary cross section was set for the measurement points; and TEM-EDS was used. The measurement conditions of the TEM-EDS were as described above. The solid solution oxygen amounts of the individual silicon nitride crystal grains included in the 20 µm×20 µm unit area were measured, and the average value of the solid solution oxygen amounts was calculated. The method for measuring the solid solution oxygen amount was as described above. FIGS. 2 to 4 are respectively the first plot diagram, the second plot diagram, and the third plot diagram when measuring the example 3. Also, the range of the solid solution oxygen amounts of the individual silicon nitride crystal grains, the average value of the solid solution oxygen amounts of the first silicon nitride crystal grains, and the average value of the solid solution oxygen amounts of the second silicon nitride crystal grains were calculated. As described above, the first silicon nitride crystal grains were silicon nitride crystal grains having major diameters of less than 5 µm. The second silicon nitride crystal grains were silicon nitride crystal grains having major diameters of not less than 5 µm.

To measure the average length of the major diameters and the average aspect ratio of the silicon nitride crystal grains 2, a 50 µm×50 µm unit area of an arbitrary cross section was set for the measurement points; and a SEM photograph was used. The method of using the SEM photograph was as described above.

The measurement results are listed in Tables 6 and 7.

**[Table 6]**

| | Solid solution oxygen amount (wt%) | | | |
|---|---|---|---|---|
| | Average value | Range of crystal grain values | Average value of first silicon nitride crystal grains | Average value of second silicon nitride crystal grains |
| Example 1 | 0.06 | 0.055-0.065 | 0.064 | 0.057 |
| Example 2 | 0.10 | 0.085-0.110 | 0.109 | 0.096 |
| Example 3 | 0.09 | 0.080-0.103 | 0.100 | 0.085 |
| Example 4 | 0.13 | 0.120-0.147 | 0.144 | 0.124 |
| Example 5 | 0.18 | 0.167-0.195 | 0.185 | 0.171 |
| Example 6 | 0.15 | 0.142-0.170 | 0.162 | 0.148 |
| Example 7 | 0.16 | 0.145-0.174 | 0.171 | 0.152 |
| Comparative example 1 | 0.25 | 0.210-0.310 | 0.281 | 0.226 |
| Comparative example 2 | 0.38 | 0.362-0.402 | 0.398 | 0.366 |
| Comparative example 3 | 0.33 | 0.290-0.485 | 0.422 | 0.311 |

**[Table 7]**

| | Silicon nitride crystal grain | |
|---|---|---|
| | Average length of major diameters (µm) | Average aspect ratio |
| Example 1 | 5.2 | 4 |
| Example 2 | 5.5 | 5 |
| Example 3 | 4.2 | 5 |
| Example 4 | 5.0 | 6 |
| Example 5 | 4.9 | 4 |
| Example 6 | 6.7 | 4 |
| Example 7 | 7.2 | 4 |
| Comparative example 1 | 5.1 | 4 |
| Comparative example 2 | 4.5 | 3 |
| Comparative example 3 | 4.8 | 4 |

It can be seen from Table 6 that the solid solution oxygen amount was not more than 0.2 wt% for the silicon nitride substrates according to the examples. In contrast, the solid solution oxygen amount was greater than 0.2 wt% for the silicon nitride substrates according to the comparative examples. There was no large difference between the examples and the comparative examples for the average value of the major diameters and the average aspect ratio of the silicon nitride crystal grains. Silicon nitride crystal grains having major diameters of less than 3 µm were present in the examples 1 to 7.

Then, the thermal conductivity and fracture toughness value of the silicon nitride substrates were measured. The thermal conductivity was measured using a laser flash method. The fracture toughness value was measured in accordance with JIS-R-1607 (the IF method) and determined using Niihara's equation. The results are shown in Table 8. JIS-R-1607 corresponds to ISO 15732.

**[Table 8]**

| | Thermal conductivity (W/m · K) | Fracture toughness value (Mpa · m^{1/2}) |
|---|---|---|
| Example 1 | 130 | 8.3 |
| Example 2 | 120 | 9.8 |
| Example 3 | 95 | 7.2 |
| Example 4 | 101 | 7.6 |
| Example 5 | 82 | 8.3 |
| Example 6 | 81 | 7.4 |
| Example 7 | 88 | 7.6 |
| Comparative example 1 | 80 | 8.1 |
| Comparative example 2 | 72 | 6.7 |
| Comparative example 3 | 77 | 7.8 |

It can be seen from Table 8 that the thermal conductivity was not less than 80 W/(m K) for the silicon nitride substrates according to the examples. Also, the thermal conductivity was not less than 100 W/(m K) for the examples 1, 2, and 4. There was no large difference between the examples and the comparative examples for the strength.

Then, the relative dielectric constant was measured for the silicon nitride substrates according to the examples and the comparative examples. The relative dielectric constant was measured in accordance with the complex permittivity measurement method (the three-terminal method) of JIS-C-2141. Measurements were performed by changing the measurement frequency between 50 Hz and 1 MHz and changing the measurement temperature between room temperature (25 °C) and 300 °C. The results are shown in Tables 9 and 10.

**[Table 9]**

| | Relative dielectric constant | | | |
|---|---|---|---|---|
| | 50Hz | | 1Mz | |
| | Room temperature | 300°C | Room temperature | 300°C |
| Example 1 | 8.3 | 8.7 | 8.4 | 8.5 |
| Example 2 | 8.3 | 8.4 | 8.1 | 8.4 |
| Example 3 | 8.4 | 8.4 | 8.2 | 8.4 |
| Example 4 | 8.3 | 8.2 | 8.1 | 8.1 |
| Example 5 | 8.3 | 8.6 | 8.3 | 8.4 |
| Example 6 | 8.3 | 8.6 | 8.3 | 8.7 |
| Example 7 | 8.3 | 8.5 | 8.2 | 8.7 |
| Comparative example 1 | 8.4 | 10.9 | 8.5 | 10.5 |
| Comparative example 2 | 8.2 | 9.9 | 8.4 | 12.3 |
| Comparative example 3 | 9.1 | 12.3 | 9.4 | 13.7 |

**[Table 10]**

| | Relative dielectric constant | | |
|---|---|---|---|
| | *ε*₅₀₋₃₀₀/*ε*₅₀₋₂₅ | *ε*_{1M-300}/*ε*_{1M-25} | *ε*_{1M-300}/*ε*₅₀₋₃₀₀ |
| Example 1 | 1.05 | 1.01 | 0.98 |
| Example 2 | 1.01 | 1.04 | 1.00 |
| Example 3 | 1.00 | 1.02 | 1.00 |
| Example 4 | 0.99 | 1.00 | 0.99 |
| Example 5 | 1.04 | 1.01 | 0.98 |
| Example 6 | 1.04 | 1.05 | 1.01 |
| Example 7 | 1.02 | 1.06 | 1.02 |
| Comparative example 1 | 1.30 | 1.24 | 0.96 |
| Comparative example 2 | 1.21 | 1.46 | 1.24 |
| Comparative example 3 | 1.26 | 1.49 | 1.20 |

It can be seen from Tables 9 and 10 that the frequency dependence and temperature dependence of the relative dielectric constant were improved for the silicon nitride substrates according to the examples. In contrast, the frequency dependence and temperature dependence of the relative dielectric constant were degraded for the comparative examples.

Thus, it can be seen that the silicon nitride substrates according to the examples were favorable as substrates for mounting semiconductor elements having high guaranteed operating temperatures or semiconductor elements having high operating frequencies.

Embodiments of the invention may include the following configurations.
Note 1 A highly thermally conductive silicon nitride sintered body, comprising:
   silicon nitride crystal grains and a grain boundary phase,
   a thermal conductivity of the silicon nitride sintered body being not less than 80 W/(m K),
   an average value of solid solution oxygen amounts of the silicon nitride crystal grains existing in a 20 µm×20 µm unit area in any cross section being not more than 0.2 wt%,
   an average value of major diameters of the silicon nitride crystal grains existing in a 50 µm×50 µm unit area in any cross section being not less than 1 µm and not more than 10 µm,
   an average of aspect ratios of the silicon nitride crystal grains existing in the 50 µm×50 µm unit area being not less than 2 and not more than 10.
Note 2 The highly thermally conductive silicon nitride sintered body according to Note 1, wherein
   a solid solution oxygen amount of each of the silicon nitride crystal grains existing in the 20 µm×20 µm unit area is within a range of not less than 0.01 wt% and not more than 0.2 wt%.
Note 3 The highly thermally conductive silicon nitride sintered body according to any one of Notes 1 to 2, wherein
   a first silicon nitride crystal grain having a major diameter of less than 5 µm and a second silicon nitride crystal grain having a major diameter of not less than 5 µm exist in the 20 µm×20 µm unit area, and
   a difference between a solid solution oxygen amount of the first silicon nitride crystal grain and a solid solution oxygen amount of the second silicon nitride crystal grain is not more than 0.03 wt%.
Note 4 The highly thermally conductive silicon nitride sintered body according to any one of Notes 1 to 3, wherein
   a content of the grain boundary phase is not less than 1 mass% and not more than 20 mass%.
Note 5 The highly thermally conductive silicon nitride sintered body according to any one of Notes 1 to 4, wherein
   the highly thermally conductive silicon nitride sintered body has a relative dielectric constant at 50 Hz and room temperature of not more than 10.
Note 6 The highly thermally conductive silicon nitride sintered body according to any one of Notes 1 to 5, wherein
   *ε*_{*50*-300}/*ε*_{*50*-25} is within a range of not less than 0.9 and not more than 1.2,
   *ε*_{*50*-25} is a relative dielectric constant at 50 Hz and room temperature, and
   *ε*_{*50*-300} is a relative dielectric constant at 50 Hz and 300 °C. Note 7
   The highly thermally conductive silicon nitride sintered body according to any one of Notes 1 to 6, wherein
   *ε*_{*1M*-300}/*ε*_{*1M*-25} is within a range of not less than 0.9 and not more than 1.2,
   *ε*_{*1M*-25} is a relative dielectric constant at 1 MHz and room temperature, and
   *ε*_{*1M*-300} is a relative dielectric constant at 1 MHz and 300 °C.
Note 8 The highly thermally conductive silicon nitride sintered body according to any one of Notes 1 to 7, wherein
   the thermal conductivity is not less than 100 W/(m K).
Note 9 A silicon nitride substrate using the highly thermally conductive silicon nitride sintered body according to any one of Notes 1 to 8.
Note 10 The silicon nitride substrate according to Note 9, wherein
   a thickness of the silicon nitride substrate is not less than 0.1 mm and not more than 3 mm.
Note 11 A silicon nitride circuit board, comprising:
   the silicon nitride substrate according to Note 9 or Note 10; and
   a circuit part located on the silicon nitride substrate.
Note 12 A semiconductor device, comprising:
   the silicon nitride circuit board according to Note 11; and
   a semiconductor element mounted to the circuit part.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments herein may be made without departing from the spirit of the inventions. These embodiments and their modifications are within the scope and spirit of the inventions and are within the scope of the inventions described in the claims and their equivalents. Also, the embodiments described above can be implemented in combination with each other.

### [Reference Numeral List]

1 highly thermally conductive silicon nitride sintered body
2 silicon nitride crystal grain
3 grain boundary phase
4 bonding layer
5 metal plate (front metal plate)
6 metal plate (back metal plate)
10 silicon nitride substrate
20 silicon nitride circuit board
30 semiconductor device
31 semiconductor element
32 leadframe

## Claims

1. A highly thermally conductive silicon nitride sintered body (1), comprising:
silicon nitride crystal grains (2) and a grain boundary phase (3),
a thermal conductivity of the silicon nitride sintered body (1) being not less than 80 W/(m·K),
an average value of solid solution oxygen amounts of the silicon nitride crystal grains (2) existing in a 20 µm×20 µm unit area in any cross section being not more than 0.2 wt%,
an average value of major diameters of the silicon nitride crystal grains (2) existing in a 50 µm×50 µm unit area in any cross section being not less than 1 µm and not more than 10 µm,
an average of aspect ratios of the silicon nitride crystal grains (2) existing in the 50 µm×50 µm unit area being not less than 2 and not more than 10.

2. The highly thermally conductive silicon nitride sintered body (1) according to claim 1, wherein
a solid solution oxygen amount of each of the silicon nitride crystal grains (2) existing in the 20 µm×20 µm unit area is within a range of not less than 0.01 wt% and not more than 0.2 wt%.

3. The highly thermally conductive silicon nitride sintered body (1) according to claim 1 or claim 2, wherein
a first silicon nitride crystal grain (2a) having a major diameter of less than 5 µm and a second silicon nitride crystal grain (2b) having a major diameter of not less than 5 µm exist in the 20 µm×20 µm unit area, and
a difference between a solid solution oxygen amount of the first silicon nitride crystal grain (2a) and a solid solution oxygen amount of the second silicon nitride crystal grain (2b) is not more than 0.03 wt%.

4. The highly thermally conductive silicon nitride sintered body (1) according to claim 1 or claim 2, wherein
a content of the grain boundary phase (3) is not less than 1 mass% and not more than 20 mass%.

5. The highly thermally conductive silicon nitride sintered body (1) according to claim 1 or claim 2, wherein
the highly thermally conductive silicon nitride sintered body (1) has a relative dielectric constant at 50 Hz and room temperature of not more than 10.

6. The highly thermally conductive silicon nitride sintered body (1) according to claim 1 or claim 2, wherein
*ε*_{*50*-300}/*ε*_{*50*-25} is within a range of not less than 0.9 and not more than 1.2,
*ε*_{*50*-25} is a relative dielectric constant at 50 Hz and room temperature, and
*ε*_{*50*-300} is a relative dielectric constant at 50 Hz and 300 °C.

7. The highly thermally conductive silicon nitride sintered body (1) according to claim 1 or claim 2, wherein
*ε*_{*1M*-300}/*ε*_{*1M*-25} is within a range of not less than 0.9 and not more than 1.2,
*ε*_{*1M*-25} is a relative dielectric constant at 1 MHz and room temperature, and
*ε*_{*1M*-300} is a relative dielectric constant at 1 MHz and 300 °C.

8. The highly thermally conductive silicon nitride sintered body (1) according to claim 1 or claim 2, wherein
the thermal conductivity is not less than 100 W/(m·K).

9. A silicon nitride substrate (10) using the highly thermally conductive silicon nitride sintered body (1) according to claim 1 or claim 2.

10. The silicon nitride substrate (10) according to claim 9, wherein
a thickness of the silicon nitride substrate (10) is not less than 0.1 mm and not more than 3 mm.

11. A silicon nitride circuit board (20), comprising:
the silicon nitride substrate (10) according to claim 9; and
a circuit part located on the silicon nitride substrate (10).

12. A semiconductor device (30), comprising:
the silicon nitride circuit board (20) according to claim 11; and
a semiconductor element (31) mounted to the circuit part.

13. The highly thermally conductive silicon nitride sintered body (1) according to claim 5, wherein
*ε*_{*50*-300}/*ε*_{*50*-25} is within a range of not less than 0.9 and not more than 1.2,
*ε*_{*50*-25} is a relative dielectric constant at 50 Hz and room temperature, and
*ε*_{*50*-300} is a relative dielectric constant at 50 Hz and 300 °C.

14. The highly thermally conductive silicon nitride sintered body (1) according to claim 13, wherein
*ε*_{*1M*-300}/*ε*_{*1M*-25} is within a range of not less than 0.9 and not more than 1.2,
*ε*_{*1M*-25} is a relative dielectric constant at 1 MHz and room temperature, and
*ε*_{*1M*-300} is a relative dielectric constant at 1 MHz and 300 °C.

15. The highly thermally conductive silicon nitride sintered body (1) according to claim 14, wherein
a first silicon nitride crystal grain (2a) having a major diameter of less than 5 µm and a second silicon nitride crystal grain (2b) having a major diameter of not less than 5 µm exist in the 20 µm×20 µm unit area, and
a difference between a solid solution oxygen amount of the first silicon nitride crystal grain (2a) and a solid solution oxygen amount of the second silicon nitride crystal grain (2b) is not more than 0.03 wt%.

16. A silicon nitride substrate (10) using the highly thermally conductive silicon nitride sintered body (1) according to claim 14.

17. A silicon nitride circuit board (20), comprising:
the silicon nitride substrate (10) according to claim 16; and
a circuit part located on the silicon nitride substrate (10).

18. A semiconductor device (30), comprising:
the silicon nitride circuit board (20) according to claim 17; and
a semiconductor element (31) mounted to the circuit part.
